# EUROPEAN PATENT APPLICATION

(11) **EP 4 851 342 A1**
(43) Date of publication of application: **09.12.2026**
(21) Application number: 24959697.4
(22) Date of filing: 05.11.2024
(51) Int. Cl.: C30B 19/06, C30B 15/32, C30B 29/36

(54) **CRYSTAL GROWTH DEVICE AND RAW MATERIAL RECYCLING METHOD**

(71) Applicant: BOYA ADVANCED MATERIALS CO., LTD., Meishan, Sichuan 620010 (CN)
(72) Inventor: WANG, Yu, Sichuan 620010 (CN); LEI, Pei, Chengdu, Sichuan 610200 (CN); GU, Peng, Sichuan 620010 (CN); YE, Shuai, Sichuan 620010 (CN)
(74) Representative: Wang, Bo
(86) International application number: PCT/CN2024/129910
(87) International publication number: WO 2026/097208

(57) **Abstract**

One or more embodiments of the present specification relate to a crystal growth device and a raw material recycling method. The device comprises: a crucible, which is configured to accommodate a crystal growth raw material; a seed crystal tray, at least part of which can be immersed in a melt formed by the crystal growth raw material in the crucible, wherein the seed crystal tray comprises a seed crystal bonding surface; and a first support structure, which is connected to the side of the seed crystal tray opposite the seed crystal bonding surface, and is configured to drive the seed crystal tray to rotate. By means of providing the first support structure to drive the seed crystal tray to rotate, the mass transfer rate is increased, and the crystal growth rate is improved. Moreover, the rotation of the seed crystal tray can also improve the radial solute distribution uniformity of the seed crystal bonding surface, thereby improving the crystal growth quality.

## Description

### TECHNICAL FIELD

The present specification relates to the technical field of crystal preparation, and in particular, to an apparatus for crystal growth and a method for material recycling.

### BACKGROUND

The manufacturing of semiconductor electronic devices and optoelectronic devices mostly requires a single crystal material, and the performance thereof is often closely related to purity, uniformity, and periodic integrity of the single crystal. Therefore, the preparation of a semiconductor single crystal has an important influence on a semiconductor device.

Therefore, the present application provides an apparatus for crystal growth and a method for material recycling to improve crystal preparation quality.

### SUMMARY

An embodiment of the present specification provides an apparatus for crystal growth. The apparatus includes a crucible for accommodating a raw material for crystal growth and a seed holder. At least a portion of the seed holder is capable of being immersed in a melt formed by the raw material for crystal growth in the crucible. The seed holder comprises a seed bonding surface. The apparatus further includes a first support structure connected to a side of the seed holder opposite the seed bonding surface. The first support structure is configured to drive the seed holder to rotate.

One or more embodiments of the present disclosure also provide a method for crystal material recycling. The method includes after crystal growth ends, acquiring a solidified remaining material in a crucible, processing the remaining material, and, based on the processed remaining material, supplementing fresh material to prepare a new raw material capable of being used for crystal growth.

### BRIEF DESCRIPTION OF THE DRAWINGS

The present specification will be further described by way of exemplary embodiments, which will be described in detail with reference to the accompanying drawings. These embodiments are not limiting, and in these embodiments, the same reference numerals denote the same structures, wherein:
FIG. 1 is a schematic structural diagram of an exemplary apparatus for crystal growth according to some embodiments of the present specification;
FIG. 2 is a schematic diagram illustrating another exemplary apparatus for crystal growth according to some embodiments of the present disclosure;
FIG. 3 is a schematic structural diagram of a connection of a source rod according to some embodiments of the present specification;
FIG. 4 is a schematic diagram illustrating an exemplary first support structure according to some embodiments of the present disclosure;
FIG. 5A is a schematic diagram of a flow guide structure according to some embodiments of the present specification;
FIG. 5B is a schematic cross-sectional view illustrating the first support structure corresponding to FIG. 5A;
FIG. 6 is a schematic structural diagram of a flow guide structure according to some embodiments of the present specification;
FIG. 7 is a schematic diagram illustrating a seed holder according to some embodiments of the present disclosure;
FIG. 8A is a schematic structural diagram of a guiding structure according to some embodiments of the present specification;
FIG. 8B is a schematic diagram illustrating an exemplary mounting plate according to some embodiments of the present disclosure;
FIGs. 9-11 are schematic structural diagrams of different seed bonding surfaces according to some embodiments of the present specification;
FIG. 12 is a schematic flow chart illustrating an exemplary process for crystal material recycling according to some embodiments of the present specification;
FIG. 13 is a flowchart illustrating a process for processing remaining material according to some embodiments of the present disclosure.
FIG. 14 is a schematic flow chart illustrating a process for preparing a new raw material for crystal growth according to some embodiments of the present specification.

### DETAILED DESCRIPTION

To more clearly illustrate the technical solutions of the embodiments of the present disclosure, a brief introduction to the accompanying drawings to be used in the description of the embodiments is provided below. Apparently, the accompanying drawings in the following description are merely some examples or embodiments of the present disclosure. For a person of ordinary skill in the art, the present disclosure may also be applied to other similar scenarios based on these accompanying drawings without inventive effort. Unless apparent from the context or otherwise specified, the same reference numerals in the drawings represent the same structures or operations.

As shown in the present disclosure and the claims, unless the context clearly indicates otherwise, words such as 'a', 'an', 'one', and/or 'the' do not exclusively refer to the singular, but may also include the plural. Generally, the terms 'comprising' and 'including' merely indicate the inclusion of explicitly identified steps and elements, and these steps and elements do not constitute an exhaustive list; a method or an apparatus may also include other steps or elements.

Flowcharts are used in the present disclosure to illustrate operations performed according to embodiments of the present disclosure. It should be understood that the preceding or following operations are not necessarily performed precisely in sequence. Rather, the various steps may be processed in reverse order or simultaneously. Meanwhile, other operations may also be added to these processes, or one or more operations may be removed from these processes.

The manufacture of semiconductor electronic devices and optoelectronic devices largely requires single crystal materials, and their performance is often closely related to the purity, uniformity, and periodic integrity of the single crystal. Therefore, the preparation of semiconductor single crystals has a significant impact on semiconductor devices. As crystal growth is a key process in the preparation of semiconductor single crystals, a higher standard is required for the quality of the crystal growth. As one of the main techniques for crystal growth, a liquid phase approach has characteristics such as fast growth speed, large crystal size, high quality of grown crystals, and wide applicability, or the like. Its basic principle is that the raw material is melted into a melt at high temperature and mixed with a flux, and the raw material precipitates at a seed crystal due to supersaturation, thereby achieving crystal growth.

The apparatus for crystal growth provided in the present disclosure drives the seed holder within the crucible to rotate by arranging the first support structure, thereby accelerating a mass transfer rate and improving the crystal growth speed. Meanwhile, the rotation of the seed holder may also improve a radial solute distribution uniformity of the seed bonding surface, thereby enhancing the crystal growth quality.

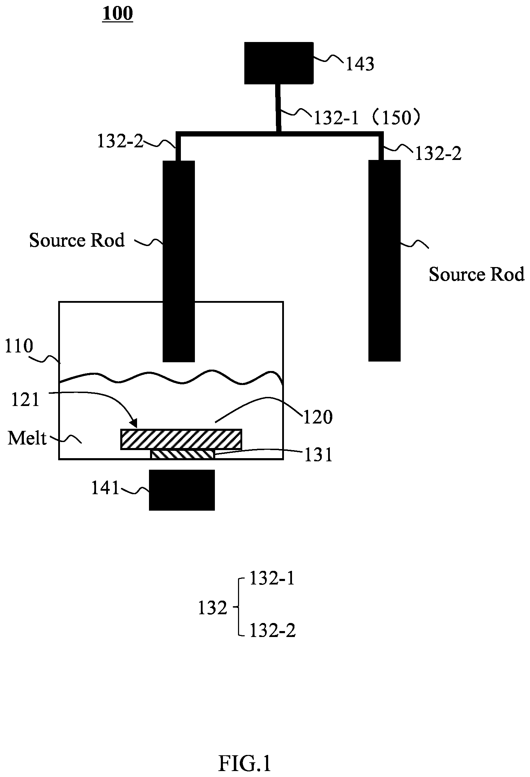

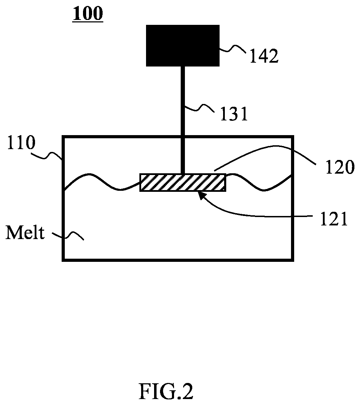

FIG. 1 is a schematic diagram illustrating an exemplary apparatus for crystal growth according to some embodiments of the present disclosure, and FIG. 2 is a schematic diagram illustrating another exemplary apparatus for crystal growth according to some embodiments of the present disclosure.

As shown in FIG. 1 and FIG. 2, an apparatus for crystal growth 100 may include a crucible 110, a seed holder 120, and a first support structure 131. The crucible 110 serves as a reaction vessel for crystal growth, and is configured to accommodate a raw material for crystal growth (e.g., carbon, silicon, or the like). In some embodiments, during the crystal growth, the raw material for crystal growth in the crucible 110 is melted into the melt, allowing the raw material to move to the seed holder 120 for crystal growth. In some embodiments, the crucible 110 may be configured to contain a flux, and the raw material for crystal growth may be dissolved or melted in the flux. In some embodiments, the raw material for crystal growth may be mixed in the flux. In some embodiments, the flux may also contain a transition material to promote crystal growth. In some embodiments, the flux may be a mixture of silicon and a small amount of transition metals or rare earth elements (e.g., Cr, Co, Al, Ce, or the like). At least a portion of the seed holder 120 is capable of being immersed in the melt in the crucible 110, allowing the melted raw material for crystal growth to move to the seed holder 120, to achieve crystal growth. In some embodiments, the seed holder 120 includes a seed bonding surface 121. The seed bonding surface 121 is immersed in the melt (i.e., the seed bonding surface 121 is located below a liquid level of the melt). The seed bonding surface 121 is configured to bond a seed crystal, and a crystal starts to grow from the seed crystal. The first support structure 131 is connected to a side of the seed holder 120 opposite to the seed bonding surface 121. The first support structure 131 is configured to drive the seed holder 120 to rotate, thereby increasing the mass transfer rate, allowing the raw material for crystal growth in the melt to precipitate around the seed crystal more quickly, and further enhancing the crystal growth rate. Meanwhile, the seed holder 120 rotating within the melt may also improve a radial distribution uniformity of the raw material for crystal growth on the seed bonding surface 121, allowing a radial growth of the crystal to be more uniform, thereby enhancing the crystal growth quality.

In some embodiments, the apparatus for crystal growth 100 may also include a heating assembly (not shown in the figures). The heating assembly may heat the crucible 110 to provide an environmental condition for crystal growth. Merely by way of example, the heating assembly may include a heating furnace body. The crucible 110 may be arranged in the heating furnace body and heated by the heating furnace body. In some embodiments, the heating assembly may adjust a temperature gradient of the crucible 110 to regulate crystal growth.

Referring to FIG. 1, in some embodiments, the seed holder 120 may be arranged at a bottom portion of the crucible 110. The seed bonding surface 121 is arranged at a top portion of the seed holder 120. A bottom portion of the seed holder 120 is connected to the bottom portion of the crucible 110 via the first support structure 131.

In this case, the heating assembly may be configured such that, in a direction from a top portion of the melt to the bottom portion of the crucible 110, a heating temperature of the heating assembly gradually decreases. That is, in the melt, the temperature of the top portion of the melt is higher, and the temperature of the bottom portion of the melt (i.e., the region where the seed bonding surface 121 is located) is lower, thereby causing convection in the melt. This allows the raw material for crystal growth in a higher temperature region within the melt to be transported to a lower temperature region (i.e., the region where the seed bonding surface 121 is located) by the convection and deposited for growth, thereby promoting the crystal growth rate. Merely by way of example, the heating temperature of the heating assembly near the top portion of the melt may be 2000°C-2200°C. The heating temperature of the heating assembly near the seed bonding surface 121 (the bottom portion of the melt) may be 1700°C-1900°C.

Correspondingly, in order to allow the first support structure 131 to drive the seed holder 120 to rotate while also achieving fixation of the seed holder 120, the first support structure 131 may include a fixing member (not shown in the figures) fixed to the bottom portion of the crucible 110, and a rotating member (not shown in the figures) rotatably connected to the fixing member. The rotating member is connected to the bottom portion of the seed holder 120. Fixation of the seed holder 120 is achieved by the fixing member, preventing instability of the seed holder 120 from affecting crystal growth. The rotating member drives the seed holder 120 to rotate, thereby improving the crystal growth rate and quality. Merely by way of example, the fixing member may include a fixing barrel. The rotating member may include a rotating shaft and a bearing. The rotating shaft is connected to an inner wall of the fixing barrel via the bearing. The rotating shaft is connected to the seed holder 120. The rotating shaft rotates relative to the fixing barrel via the bearing, while driving the seed holder 120 to rotate.

In some embodiments, the apparatus for crystal growth 100 may also include a first rotating mechanism 141 configured to drive the first support structure 131 to rotate. The first rotating mechanism 141 is arranged outside the crucible 110 to provide a suitable working environment for the first rotating mechanism 141. The first rotating mechanism 141 is magnetically connected to the first support structure 131, allowing the first rotating mechanism 141 to be located outside the crucible 110 while facilitating the connection between the first rotating mechanism 141 and the first support structure 131 without damaging the crucible 110, thereby preventing leakage of the contents of the crucible 110 (e.g., the flux, the melt, or the like). The first rotating mechanism 141 may drive the first support structure 131 to rotate by a magnetic force, thereby causing the seed holder 120 to rotate. Merely by way of example, the first rotating mechanism 141 may include a non-contact rotary motor.

Referring to FIG. 2, in some embodiments, the seed holder 120 may also be arranged at the top portion of the melt. In this case, the seed bonding surface 121 may be located at the bottom portion of the seed holder 120, thereby allowing the seed bonding surface 121 to be capable of being immersed in the melt and capable of being located below the liquid surface of the melt. In this case, the first support structure 131 is connected to the top portion of the seed holder 120, and the first support structure 131 may extend from an opening of the crucible 110.

In some embodiments, in order to fix the seed holder 120, the first support structure 131 may be physically connected to a second rotating mechanism 142. The fixing of the seed holder 120 is achieved through direct or indirect connection between the second rotating mechanism 142 and the external support or the heating assembly (e.g., the heating furnace body). In some embodiments, the first support structure 131 is in a transmission connection with the second rotating mechanism 142, and the second rotating mechanism 142 drives the seed holder 120 to rotate via the first support structure 131. In some embodiments, the second rotating mechanism 142 may include a driving motor, or the like.

In this case, the heating assembly may be configured such that the heating temperature gradually increases in a direction from the top portion of the melt to the bottom portion of the crucible 110. That is, in the melt, the temperature of the top portion of the melt (i.e., the region where the seed bonding surface 121 is located) is lower, and the temperature of the bottom portion of the melt is higher, thereby causing the melt to undergo convection. The raw material from the higher temperature region in the melt is transported to the lower temperature region (i.e., the region where the seed bonding surface 121 is located) under the action of the convection, and is deposited and grows, thereby promoting the crystal growth rate. Exemplarily, the heating temperature of the heating assembly near the bottom portion of the melt may be 2000°C to 2200°C, and the heating temperature of the heating assembly near the seed bonding surface 121 (the top portion of the melt) may be 1700°C to 1900°C.

Referring to FIG. 1, in some embodiments, the raw material for crystal growth may further include at least one source rod, wherein the at least one source rod is capable of being at least partially immersed in the melt. The flux may etch at least one source rod, thereby allowing the at least one source rod to dissolve in the melt and, as a solute, deposit and grow on the seed bonding surface 121 through diffusion. In some embodiments, the material of a source rod may include graphite, SiC ceramic, or a single crystal, in order to provide the raw material for crystal growth.

In some embodiments, the apparatus for crystal growth 100 may further include a second support structure 132. One end of a source rod (e.g., the end facing away from the bottom portion of the crucible 110) may be connected to the second support structure 132, thereby fixing the source rod via the second support structure 132. The second support structure 132 may be directly or indirectly connected to the external support or the heating assembly (e.g., a heating furnace body section).

In some embodiments, the apparatus for crystal growth 100 may further include a driving structure 143. The second support structure 132 comprises a main rod 132-1 and a plurality of auxiliary rods 132-2 spaced apart from each other. One end of each of the plurality of auxiliary rods 132-2 is respectively connected to at least one of the at least one source rod, the other end of each of the plurality of auxiliary rods 132-2 is connected to the main rod 132-1, and the main rod 132-1 is connected to the driving structure 143. The driving structure 143 drives the second support structure 132 to move so that different source rods are capable of being immersed in the melt, thereby switching the source rods immersed in the melt, facilitating fast switching of the source rods, and improving operation efficiency.

In some embodiments, a direction in which the plurality of auxiliary rods 132-2 are spaced apart may correspond to a driving direction of the driving structure 143, in order to allow the different source rods to be capable of being immersed in the melt. For example, as shown in FIG. 1, the plurality of auxiliary rods 132-2 may be spaced apart along a circumferential direction, and the driving direction of the driving structure 143 is the circumferential direction. As another example, the plurality of auxiliary rods 132-2 may be spaced apart along the horizontal direction, and the driving direction of the driving structure 143 is the corresponding horizontal direction.

In some embodiments, each of the plurality of auxiliary rods 132-2 may be connected to at least one source rod, thereby facilitating control of the number of source rods immersed in the melt, facilitating adjustment of the amount of raw material in the melt, and thereby controlling the crystal growth.

In some embodiments, in order to allow the different source rods to be capable of being immersed in the melt and to avoid the crucible 110 obstructing the switching of the source rods, the crucible 110 may be arranged on a lifting device (not shown). When it is necessary to switch the source rods, the lifting device may be driven to descend, thereby lowering the position of the crucible 110 and moving a source rod out of the crucible 110. After the source rod is completely moved out of the crucible 110, the driving structure 143 may then drive the second support structure 132 to move and switch another source rod corresponding to the crucible 110. After another source rod is moved above the crucible 110, the lifting device may then be driven to ascend, thereby immersing the another source rod in the melt to continue the crystal growth.

In some embodiments, in order to allow the different source rods to be capable of being immersed in the melt and to avoid the crucible 110 obstructing the switching of the source rods, the lifting and lowering of the source rods may also be controlled. In some embodiments, the main rod 132-1 may be connected to a telescopic structure 150 (as shown in FIG. 1), or each of the plurality of auxiliary rods 132-2 is connected to a corresponding telescopic structure 150. The plurality of telescopic structures 150 are respectively or collectively in a driving connection with the driving structure 143 via the main rod. The telescopic structure 150 may extend and retract to immerse a source rod in the melt or to lift the source rod out of the melt.

The arrangement of the telescopic structure 150 may facilitate control of the crystal growth. Specifically, when the length of the source rod is known, the source rod is immersed in the melt by a preset length via the telescopic structure 150, thereby causing the top portion of the melt to be at a preset position on the source rod, thereby controlling the amount of raw material dissolved in the melt, and further controlling the condition and parameters of the crystal growth.

In some embodiments, the arrangement of the telescopic structure 150 may also facilitate replacement of the source rod. Specifically, after the source rod reaches a predetermined consumption amount (e.g., the preset length is consumed, or completely consumed, or the like), the source rod may be lifted out of the melt via the telescopic structure 150, in order to facilitate replacement of the source rod. Further, after the telescopic structure 150 lifts the current source rod out of the melt, the driving structure 143 may operate (e.g., by driving an auxiliary rod 132-2 to rotate by a corresponding angle, or by driving an auxiliary rod 132-2 to displace by a corresponding distance in the corresponding horizontal direction), to move the current source rod away from the opening of the crucible 110, and at the same time, to move another source rod to the opening of the crucible 110, and to immerse another source rod in the melt via the telescopic structure 150, to replenish the raw material in the melt.

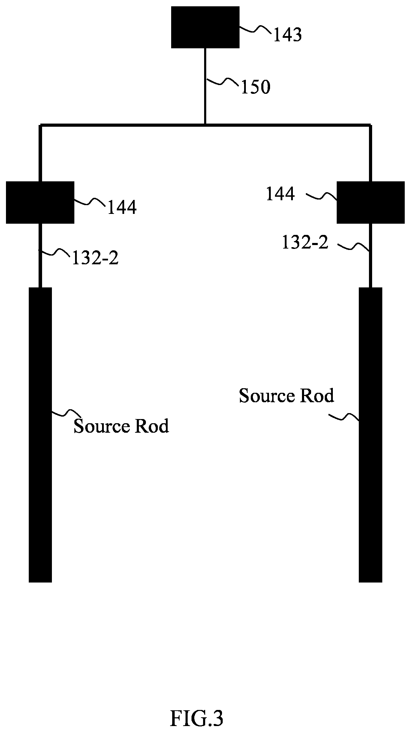

FIG. 3 is a schematic diagram illustrating a connection structure of the source rod according to some embodiments of the present disclosure. Referring to FIG. 3, in some embodiments, each of the plurality of auxiliary rods 132-2 may be in a transmission connection with a corresponding third rotating mechanism 144. The plurality of third rotating mechanisms 144 are all connected to the main rod 132-1, as shown in FIG. 3. Each of the third rotating mechanisms 144 may drive the corresponding source rod to rotate, thereby enhancing the uniformity of contact between the source rod and the melt, accelerating the etching strength of the flux in the melt on the source rod, strengthening material supply, and improving the crystal formation effect.

In some embodiments, the second support structure 132 may also only include a single auxiliary rod 132-2. That is, the second support structure 132 may only be connected to the single source rod. In this case, the second support structure 132 may also be directly in a transmission connection with the third rotating mechanism 144. The third rotating mechanism 144 may drive the second support structure 132 to rotate, so as to drive the source rod to rotate, thereby enhancing the uniformity of contact between the source rod and the melt, accelerating the etching strength of the flux in the melt on the source rod, strengthening material supply, and improving the crystal formation effect.

In some embodiments, the third rotating mechanism 144 may be connected and fixed to the external support or the heating assembly (e.g., the heating furnace body). In some embodiments, the third rotating mechanism 144 may be connected to the driving structure 143. In some embodiments, the telescopic structure 150 may also be provided between the third rotating mechanism 144 and the source rod, or between the driving structure 143 and the third rotating mechanism 144. More descriptions regarding the telescopic structure 150 may be found in the preceding related descriptions.

It should be noted that, except for the first support structure 131 and the first rotating mechanism 141 when the seed holder 120 is arranged at the bottom portion of the crucible 110, the support structures in other cases (e.g., the first support structure 131 and the second support structure 132 when the seed holder 120 is arranged at the top portion of the crucible 110, or the like) may have the same or similar structure, and the rotating mechanisms (e.g., the second rotating mechanism 142, the third rotating mechanism 144, or the like) may have the same or similar structure.

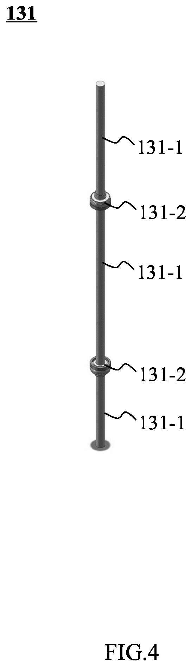

FIG. 4 is a schematic diagram illustrating an exemplary first support structure according to some embodiments of the present disclosure. As shown in FIG. 4, in some embodiments, the first support structure 131 may include a plurality of support rods 131-1 connected end-to-end in sequence, and any two adjacent support rods 131-1 may be nested and connected via a bearing 131-2. In some embodiments, the first support structure 131 may further include a protective layer (not shown in the figure). The support rods 131-1 and the bearing 131-2 are both arranged within the protective layer. The protective layer separates the support rods 131-1 and the bearing 131-2 from the outside, thereby providing protection and improving the operational stability of the first support structure 131.

The outer ring of the bearing 131-2 may be connected to the inner wall of the protective layer, and opposite ends between the two adjacent support rods 131-1 are nested in the corresponding inner ring of the bearing 131-2. By limiting the rotational oscillation of the support rods 131-1 via the bearing 131-2, the stability of the support rods 131-1 during high-speed rotation can be achieved. Moreover, the arrangement of the bearing 131-2 allows an inner cavity of the bearing 131-2 to be relatively stationary with respect to the support rods 131-1 when the support rods 131-1 rotate, and an outer ring of the bearing 131-2 to be relatively stationary with respect to the protective layer. The wear and tear produced by the bearing 131-2 during the rotation of the support rods 131-1 has a small impact on the support rods 131-1, thereby improving a service life of the first support structure 131. Furthermore, after the bearing 131-2 is damaged, it is easy to replace and has a lower replacement cost, thereby reducing the cost of use.

It should be noted that the above-described structure is that of the first support structure 131 when the seed holder 120 is arranged at the top portion of the melt within the crucible 110. A structure of the second support structure 132 may be the same as or similar to the structure of the first support structure 131.

In some embodiments, the rotation speed of the first support structure 131 or the second support structure 132 may be 10 rpm-200 rpm. That is, the corresponding rotation speed of the seed holder 120 or the source rod may be 10 rpm-200 rpm. By designing the rotation speed of the seed holder 120, the mass transfer rate may be increased, the growth rate of the crystal may be improved, and the radial distribution uniformity of the raw material on the seed bonding surface 121 may be simultaneously improved, thereby enhancing the growth quality of the crystal. By designing the rotation speed of the source rod, the uniformity of contact between the source rod and the melt may be enhanced, the etching rate of the source rod may be promoted, and the crystal generation effect may be improved. In some embodiments, in order to further improve the growth rate of the crystal and enhance the growth effect of the crystal, the rotation speed of the first support structure 131 or the second support structure 132 may be 20 rpm-150 rpm.

In some embodiments, the rotation speed of the first support structure 131 is negatively correlated with the temperature at the seed holder 120. Under the condition that the temperature in other regions of the melt is constant, the higher the temperature at the seed holder 120 (seed bonding surface 121), the smaller the temperature gradient in the axial direction between the seed holder 120 and other regions of the melt, and the more difficult it is for the raw material within the melt to be transported to the seed bonding surface 121 for deposition growth. In this case, in order to improve the growth rate and quality of the crystal, the rotation speed of the first support structure 131 is required to be higher. The axial direction refers to a direction perpendicular to the seed bonding surface 121, that is, the depth direction of the crucible 110. Similarly, under the condition that the temperature in other regions of the melt is constant, the lower the temperature at the seed holder 120 (seed bonding surface 121), the larger the temperature gradient in the axial direction between the seed holder 120 and other regions of the melt, and the easier it is for the raw material within the melt to be transported to the seed bonding surface 121 for deposition growth. In this case, the rotation speed of the first support structure 131 is required to be lower.

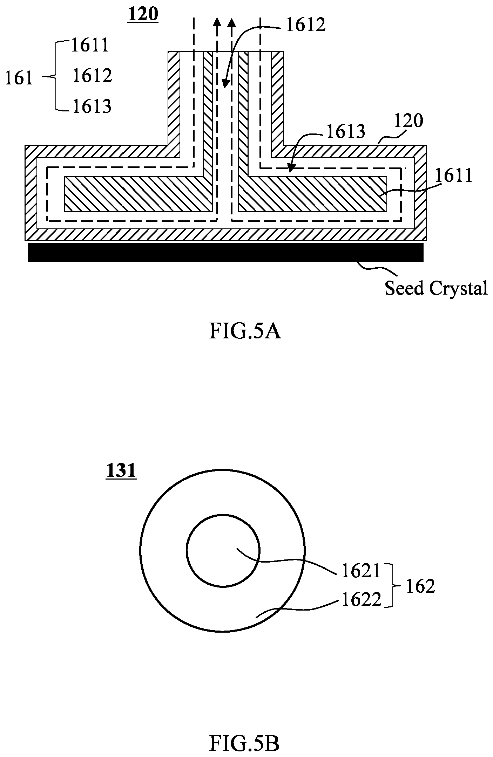

FIG. 5A is a schematic diagram illustrating a flow guide structure according to some embodiments of the present disclosure, and FIG. 5B is a cross-sectional schematic diagram of the first support structure corresponding to FIG. 5A.

Referring to FIG. 5A and FIG. 5B, in some embodiments, the apparatus for crystal growth 110 may further include a cooling assembly (not labeled in the figure). The cooling assembly may include a flow guide structure 161 arranged within the seed holder 120. The flow guide structure 161 may be configured to guide a cooling medium, thereby causing the cooling medium to cool the seed bonding surface 121, allowing for a more uniform radial temperature distribution of the seed bonding surface 121 and a lower temperature in the vicinity of the seed bonding surface 121. This also increases the temperature gradient in the axial direction between the seed bonding surface 121 and other regions of the melt, thereby improving the growth rate and quality of the crystal.

In some embodiments, the cooling assembly may further include a hollow structure 162 arranged within the first support structure 131. The hollow structure 162 is in communication with the flow guide structure 161, so as to facilitate conveying the cooling medium through the first support structure 131 to the flow guide structure 161, or recovering the cooling medium from the flow guide structure 161. Additionally, the arrangement of the hollow structure 162 may also separate the cooling medium from the outside, to prevent the cooling medium from being affected by external factors, which could lead to a temperature rise and weakened cooling capacity. In some embodiments, the hollow structure 162 may be arranged within the support rods 131-1. In some embodiments, the support rods 131-1, the bearing 131-2, and the protective layer may be arranged within the hollow structure 162.

In some embodiments, the hollow structure 162 comprises a first cooling channel 1621 and a second cooling channel 1622. The flow guide structure 161 comprises a flow guiding ring 1611 arranged in the seed holder 120. The middle portion of the flow guiding ring 1611 is provided with an inner hole 1612, and the inner hole 1612 of the flow guiding ring 1611 is in communication with the first cooling channel 1621. A cavity space 1613 between the flow guiding ring 1611 and a housing of the seed holder 120 is in communication with the second cooling channel 1622, and the cavity space 1613 is in communication with the inner hole 1612. The inner hole 1612 is arranged in a middle portion of the seed holder 120. The cooling medium enters the cavity space 1613 through the second cooling channel 1622, and then enters the first cooling channel 1621 from the inner hole 1612 to be recovered and output. Alternatively, the cooling medium enters the inner hole 1612 through the first cooling channel 1621, and then enters the second cooling channel 1622 from the cavity space 1613 to be recovered and output. Through the aforementioned design, the cooling medium is kept in an enclosed structure, which minimizes the impact of the cooling medium on the temperature and the flow field within the crucible 110, thereby improving the stability of crystal growth.

The design of the flow guiding ring 1611, the inner hole 1612, and the cavity space 1613 may control the directional flow of the cooling medium, ensuring that the cooling medium circulates without accumulation, and preventing uneven action, disordered flow, or inability to timely discharge the heated cooling medium. Additionally, the arrangement of the flow guiding ring 1611 may also reduce the impact of the cooling medium on the seed bonding surface 121, and reduce pressure on the seed bonding surface 121.

In some embodiments, the first cooling channel 1621 is arranged within the second cooling channel 1622, and the second cooling channel 1622 surrounds the first cooling channel 1621. In some embodiments, the first cooling channel 1621 and the second cooling channel 1622 may be directly arranged within the support rods 131-1. In other embodiments, the support rods 131-1 may also be arranged within the first cooling channel 1621, and the protective layer separates the support rods 131-1 from the first cooling channel 1621.

The top portion of the cavity space 1613 is in communication with the second cooling channel 1622, and the bottom portion of the cavity space 1613 is in communication with the inner hole 1612. The second cooling channel 1622 is configured to input the cooling medium into the cavity space 1613. The first cooling channel 1621 is configured to recover and output the cooling medium guided by the inner hole 1612. That is, on the seed bonding surface 121, the flow direction of the cooling medium is from the edge of the seed bonding surface 121 to the center of the seed bonding surface 121, as shown in FIG. 5A.

Since the heating assembly surrounds the outside of the crucible 110, the edge of the seed bonding surface 121 is closer to the heating assembly, and the edge temperature of the seed bonding surface 121 is higher than the center temperature of the seed bonding surface 121. However, through the aforementioned guiding arrangement, the cooling medium first cools the edge region of the seed bonding surface 121. When the cooling medium is conveyed to the central region of the seed bonding surface 121, the temperature of the cooling medium will inevitably increase compared to an initial temperature (e.g., the temperature when the cooling medium enters the cavity space 1613). This thereby reduces the cooling capacity of the cooling medium for the central region of the seed bonding surface 121. Consequently, the cooling medium provides a more effective cooling effect on the higher-temperature edge region of the seed bonding surface 121. In comparison, its cooling effect on the lower-temperature central region of the seed bonding surface 121 is relatively poorer. Ultimately, this results in the more uniform radial temperature distribution of the seed bonding surface 121, thereby avoiding local two-dimensional nucleation.

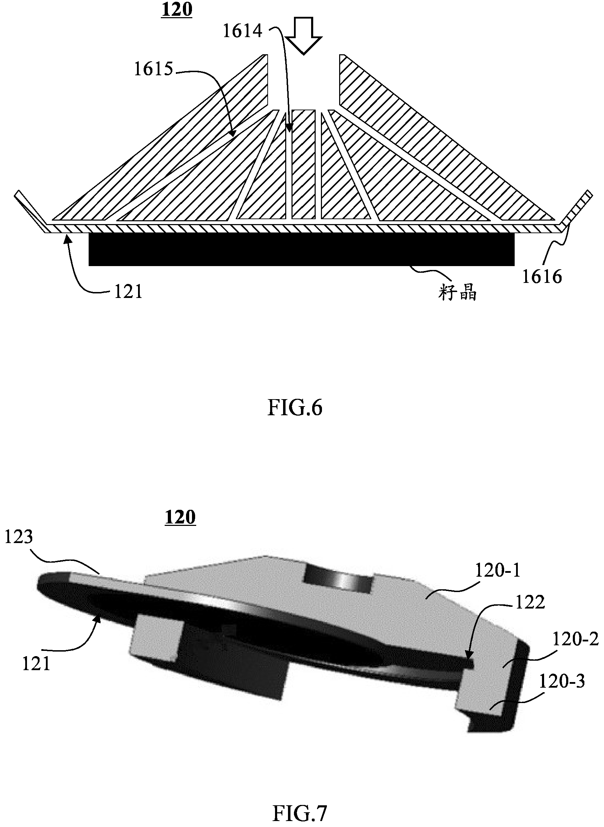

FIG. 6 is a schematic diagram illustrating a flow guide structure according to some embodiments of the present disclosure. Referring to FIG. 6, in some embodiments, the flow guide structure 161 comprises a central channel 1614 and a peripheral channel 1615. The peripheral channel 1615 is arranged surrounding the central channel 1614. A flow guide inlet of the central channel 1614 and a flow guide inlet of the peripheral channel 1615 are both arranged at a top portion of the seed holder 120. The flow guide inlet of the central channel 1614 and the flow guide inlet of the peripheral channel 1615 are respectively in communication with the hollow structure 162. A flow guide outlet of the peripheral channel 1615 is located at an edge region of the seed bonding surface 121, and a flow guide outlet of the central channel 1614 is located at a central region of the seed bonding surface 121.

Through the arrangement of the central channel 1614 and the peripheral channel 1615, the cooling medium is enabled to cool a larger area of the seed bonding surface 121 and cool the seed bonding surface 121 more uniformly, thereby making the temperature distribution of the seed bonding surface 121 more uniform.

In some embodiments, the seed bonding surface 121 of the seed holder 120 is provided with a baffle plate 1616. In a direction perpendicular to the seed bonding surface 121 (that is, the axial direction), an area of the baffle plate 1616 is larger than an area of the seed bonding surface 121. The baffle plate 1616 may prevent the cooling medium from directly contacting the seed bonding surface 121, thereby avoiding overcooling of the seed bonding surface 121 and affecting the crystal crystallization growth. Additionally, after the cooling medium output from the flow guide outlet of the central channel 1614 and the flow guide outlet of the peripheral channel 1615 contacts the baffle plate 1616, it moves toward the edge region of the seed bonding surface 121. That is, overall, the total amount of the cooling medium passing through the central region of the seed bonding surface 121 is smaller, while the total amount of the cooling medium passing through the edge region of the seed bonding surface 121 is larger. This consequently leads to a poorer cooling effect on the lower-temperature central region of the seed bonding surface 121, and a better cooling effect on the higher-temperature edge region of the seed bonding surface 121. Ultimately, this ensures the more uniform radial temperature distribution of the seed bonding surface 121, thereby avoiding local two-dimensional nucleation.

In some embodiments, an edge of the baffle plate 1616 is provided with a flow guide plate. The flow guide plate extends toward the top of the seed holder 120 to minimize direct contact between the cooling medium and the seed bonding surface 121, thereby reducing the effect on crystal growth. In some embodiments, an angle between the flow guide plate and the baffle plate 1616 is 95°-130°, thereby facilitating the dissipation of the cooling medium toward the surroundings after cooling is completed, and avoiding accumulation of the cooling medium.

In some embodiments, when the flow guide structure 161 is the structure shown in FIG. 5A, the cooling medium may be a gas or a liquid. When the flow guide structure 161 is the structure shown in FIG. 6, the cooling medium may be a gas to reduce its impact on the temperature of the crucible 110.

In some embodiments, the side portion and the top portion of the seed holder 120 may be coated with a protective layer to protect the seed holder 120, insulate it from the melt, and minimize polycrystalline growth on the seed holder 120. In some embodiments, the protective layer may be fixed on the surface of the seed holder by means of a threaded connection or bonding.

In some embodiments, to adapt to the crystal growth environment, the material of the protective layer has a high-temperature resistance characteristic. In some embodiments, to avoid interference with crystal growth, the material of the protective layer has high physicochemical stability and exhibits non-wettability with respect to the melt (e.g., a flux). In some embodiments, the material of the protective layer may include at least one of SiC, silicon nitride (Si3N4), silicon dioxide (SiO2), aluminum oxide (Al2O3), or magnesium oxide (MgO).

In some embodiments, to isolate the seed holder 120 from the melt, the thickness of the protective layer may be 0.5 mm - 20 mm. In some embodiments, to meet design requirements, the thickness of the protective layer may be 1 mm to 15 mm.

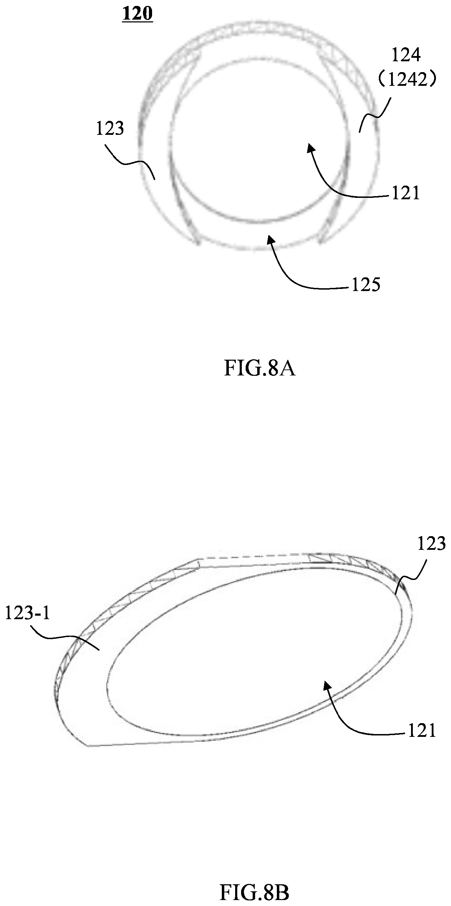

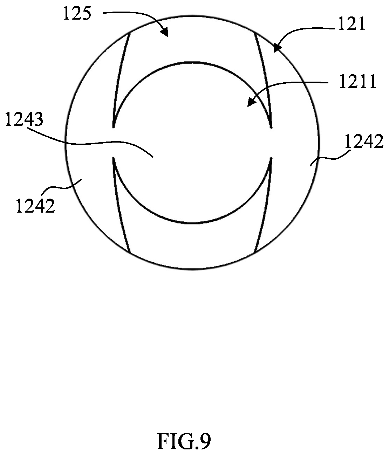

FIG. 7 is a schematic diagram illustrating a structure of the seed holder according to some embodiments of the present disclosure, FIG. 8A is a schematic diagram illustrating a structure of a guiding structure according to some embodiments of the present disclosure, FIG. 8B is a schematic diagram illustrating a structure of a mounting plate according to some embodiments of the present disclosure, and FIGs. 9 to 11 are schematic diagrams illustrating different seed bonding surfaces according to some embodiments of the present disclosure. The structure of the seed holder 120 will be described below in conjunction with FIGs. 7 to 11.

In some embodiments, a middle portion of the seed bonding surface 121 may be provided with a bonding region 1211, the seed bonding surface 121 may be provided with a guiding structure 124, the guiding structure 124 is capable of forming a guiding channel 125, and the bonding region 1211 is located in the guiding channel 125.

In some embodiments, the guiding structure 124 may achieve a guiding effect, increase the flow effect of the melt, improve uniformity of the raw material in the melt, and simultaneously ensure sufficient contact between the seed bonding surface 121 and the melt, thereby improving the crystal growth quality. In another aspect, when the melt flows into the guiding structure 124, the guiding structure 124 may provide a buffering effect, effectively smoothing disordered fluctuations of the melt, reducing the influence of the Lorentz force, and improving the crystal growth quality.

Referring to FIGs. 7 to 8B, in some embodiments, the seed holder 120 comprises a first layer structure 120-1, a second layer structure 120-2, and a third layer structure 120-3 sequentially arranged along a height direction. The first layer structure 120-1 of the seed holder 120 is configured to be connected to the first support structure 131. The second layer structure 120-2 of the seed holder 120 is provided with a slot 122. The slot 122 is configured to cooperate with and engage a mounting plate 123. A side of the mounting plate 123 facing away from the first layer structure 120-1 is provided with a seed mounting surface 121. And the third layer structure 120-3 of the seed holder 120 is provided with the guiding structure 124.

In some embodiments, the mounting plate 123 is provided with an extension portion 123-1. In an installed state, the extension portion 123-1 may extend out of the slot 122, thereby facilitating the removal and disassembly, installation, and replacement of the mounting plate 123.

In some embodiments, the material of the mounting plate 123 may be selected from materials having poor heat absorption capacity, thereby allowing the seed bonding surface 121 to be at a lower temperature, enhancing the temperature gradient between the seed bonding surface 121 and other regions of the melt in an axial direction, and improving the speed and quality of crystal growth. In some embodiments, the mounting plate 123 may comprise a material with stable mass-transfer properties to improve crystal growth quality. In some embodiments, the material of the mounting plate 123 may comprise graphite.

In some embodiments, the first layer structure 120-1, the second layer structure 120-2, and the third layer structure 120-3 of the seed holder 120 may be separately connected or may be integrally formed.

As shown in FIG. 9, in some embodiments, the guiding structure 124 may comprise guiding protrusions 1242 arranged on two sides of the seed bonding surface 121, the guiding channel 125 is formed between the two guiding protrusions 1242, a middle portion of the guiding channel 125 is provided with a mounting protrusion 1243. The bonding region 1211 is located on the mounting protrusion 1243. The melt flows through the guiding channel 125 to the bonding region 1211, thereby achieving guiding and buffering effects. Meanwhile, in the guiding channel 125, the guiding channel 125 and the mounting protrusion 1243 form a stepped structure, allowing crystal growth to proceed in a step-coverage manner. By controlling the crystal to grow against the direction of the steps, crystal growth is slowed, but growth quality improves.

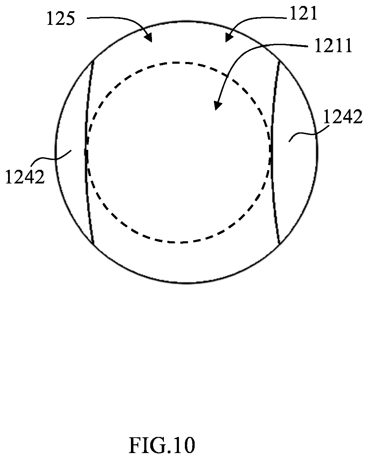

As shown in FIG. 10, in some embodiments, the guiding structure 124 may comprise guiding protrusions 1242 arranged on two sides of the seed bonding surface 121, the guiding channel 125 is formed between the two guiding protrusions 1242, and the bonding region 1211 is located at the middle portion of the guiding channel 125. The melt flows through the guiding channel 125 to the bonding region 1211, thereby achieving guiding and buffering effects.

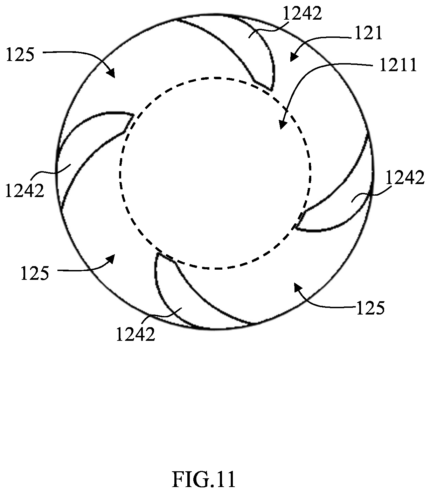

As shown in FIG. 11, in some embodiments, the guiding structure 124 may comprise a plurality of guiding protrusions 1242 arranged surrounding the bonding region 1211, the plurality of guiding protrusions 1242 respectively extend from an edge of the seed bonding surface 121 toward the bonding region 1211 at the middle portion of the seed bonding surface 121, and the guiding channel 125 is formed between any adjacent guiding protrusions 1242. The melt flows through the guiding channels 125 between the plurality of guiding protrusions 1242 to the bonding region 1211, thereby achieving guiding and buffering effects.

In some embodiments, an arrangement of the guiding protrusions 1242 may cause small turbulences to form at the guiding protrusions 1242 during rotation of the seed holder 120, changing the flow rate and the flow direction of the melt, thereby achieving guiding and buffering effects.

In some embodiments, the height difference of the guiding structure 124 is less than or equal to 1 mm, so that the bonding region 1211 of the seed bonding surface 121 may be immersed in the melt. Merely by way of example, for the structure shown in FIG. 9, the end surfaces of the guiding protrusions 1242 and the mounting protrusion 1243 may be located in the same plane. The height difference between the end surfaces of the guiding protrusions 1242 or the mounting protrusion 1243 and the bottom of the guiding channel 125 is less than or equal to 1 mm. For the structure shown in FIG. 10, the height difference between the end surfaces of the guiding protrusions 1242 and the bottom of the guiding channel 125 is less than or equal to 1 mm. For the structure shown in FIG. 11, the end surfaces of the guiding protrusions 1242 are located in the same plane, and the height difference between the end surfaces of any guiding protrusion 1242 and the bonding region 1211 is less than or equal to 1 mm.

If the diameter of the seed holder 120 differs too much from the inner diameter of the crucible 110, when the seed holder 120 rotates to drive the melt in the crucible 110, it may cause a small flow rate of the melt, resulting in uneven distribution of the raw material in the melt, insufficient contact between the melt and the seed bonding surface 121, and affecting the crystal growth effect. If the diameter of the seed holder 120 is too close to the inner diameter of the crucible 110, the seed holder 120 may interfere with the inner diameter of the crucible 110 when rotating, which poses a safety hazard. In some embodiments, to improve crystal growth and increase safety, the ratio of the diameter of the seed holder 120 to the inner diameter of the crucible 110 may be 4/5 to 7/8. In some embodiments, to further improve the crystal growth effect, the ratio of the diameter of the seed holder 120 to the inner diameter of the crucible 110 may be 5/6 to 6/7.

In some embodiments, when the diameter of the seed holder 120 is smaller than the diameter of the crystal, it may cause a smaller area of the seed bonding surface 121, the crystal receives limited stress, and the crystal is not prone to cracking. When the diameter of the seed holder 120 is greater than or equal to the diameter of the crystal, it provides better support for the crystal, resulting in a thicker, flatter crystal. In some embodiments, to improve crystal growth quality, the ratio of the diameter of the seed holder 120 to the diameter of the crystal may be 0.5 to 1.5.

In some embodiments, the diameter of a support rod 131-1 of the first support structure 131 may affect the rotation speed of the seed holder 120 and the delivery amount of the cooling medium. If the diameter of the first support structure 131 is too small, it may limit the rotation speed of the seed holder 120 and reduce the delivery amount of the cooling medium, leading to a higher temperature of the seed bonding surface 121, which affects crystal growth. If the diameter of the first support structure 131 is too large, it may increase installation difficulty and increase material costs. In some embodiments, to reduce material costs and improve crystal growth quality, the ratio of the diameter of the seed holder 120 to the diameter of the support rod 131-1 may be 3.5 to 16. In some embodiments, to further improve crystal growth quality, the ratio of the diameter of the seed holder 120 to the diameter of the support rod 131-1 may be 8 to 10

In some embodiments, the crucible 110 may also be connected to a third support structure (not shown in the figures). The third support structure may be connected to a rotating mechanism, and the rotating mechanism drives the crucible 110 to rotate via the third support structure, thereby driving the melt in the crucible 110 to rotate, improving the mass transfer rate, increasing the crystal growth rate, improving uniformity of raw material distribution in the melt, and improving the crystal growth quality. In some embodiments, in order to improve the crystal growth quality, the rotation speed of the third support structure may be 10 rpm to 200 rpm. In some embodiments, in order to further improve the crystal growth quality, the rotation speed of the third support structure may be 150 rpm to 200 rpm.

In some embodiments, the rotation speed of the first support structure 131 and the rotation speed of the third support structure may affect the mass transfer rate between the melt in the crucible 110 and the seed bonding surface 121. In a case where the rotation directions of the first support structure 131 and the third support structure are the same, the closer the rotation speed of the first support structure 131 is to the rotation speed of the third support structure, the lower the mass transfer rate. In some embodiments, in order to improve the crystal growth quality, the ratio of the rotation speed of the third support structure to the rotation speed of the first support structure 131 may be 0.4 to 0.75.

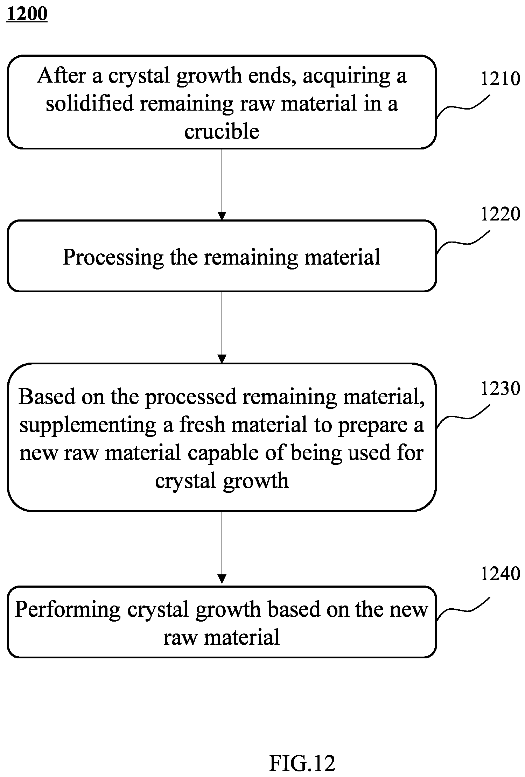

FIG. 12 is a flowchart illustrating an exemplary process for crystal material recycling according to some embodiments of the present disclosure. The present disclosure also provides a method for crystal material recycling, which processes the remaining material after crystal growth ends and supplements the fresh material to perform the next crystal growth, thereby saving material costs and improving efficiency of crystal growth. In some embodiments, the method for crystal material recycling may be performed by the apparatus for crystal growth 100. In some embodiments, referring to FIG. 12, the method for crystal material recycling may include process 1200, and process 1200 may include the following steps:

In 1210, a solidified a remaining raw material in a crucible is acquired after crystal growth ends.

In some embodiments, after the previous crystal growth is completed, the crucible 110 with the remaining material may be taken out from a growth chamber to acquire the remaining material in the crucible 110. The growth chamber refers to the chamber in which the crucible 110 is placed. The growth chamber may provide conditions required for crystal growth (e.g., temperature, or the like) for the crucible 110. An overall structure or partial components such as a heating assembly, a cooling assembly, or the like, may also be arranged in the growth chamber. In some embodiments, the remaining material may include a source rod portion that is etched and integrated into the melt by the flux in the melt, a transition substance, or the like.

In some embodiments, after crystal growth is completed and the crucible 110 is removed, the crucible 110 is transformed from a high-temperature environment to a normal-temperature environment, and the remaining material in the crucible 110 solidifies and bonds to the bottom portion of the crucible 110. In some embodiments, the solidified remaining material may be removed from the crucible 110 by a tool. For example, the solidified material may be separated from the surface of the crucible by a hammer made of tungsten carbide.

In 1220, the remaining material is processed.

In some embodiments, by processing the remaining material, the impurities in the remaining material may be removed, so as to retain a material blend ratio related to the raw material for crystal growth.

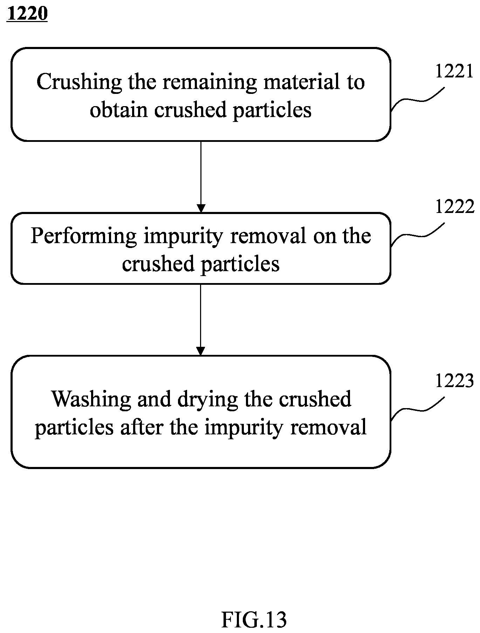

FIG. 13 is a flowchart illustrating an exemplary process for processing the remaining material according to some embodiments of the present disclosure. As shown in FIG. 13, in some embodiments, step 1220 may include a plurality of sub-steps, e.g., step 1221, step 1222, and step 1223.

In 1221, the remaining material is crushed to obtain crushed particles.

By crushing the remaining material, the volume of the remaining material may be reduced, which facilitates subsequent processing.

In some embodiments, the remaining material may be crushed into solid crushed particles of various sizes by the aforementioned hammer made of tungsten carbide. In some embodiments, process 1200 may also include screening the particle sizes of the crushed particles to obtain first particles having a particle size greater than or equal to a preset threshold and second particles having a particle size less than the preset threshold. In some embodiments, the preset threshold may be preset, or may be determined based on an average size of the crushed particles. In some embodiments, the preset threshold may be 3 mm, that is, the crushed particles having a particle size greater than or equal to 3 mm after screening may be classified as the first particles, and the crushed particles having a particle size less than 3 mm after screening may be classified as the second particles. Specifically, the crushed particles may be screened by a sieving machine having a sieve pore size of the preset threshold. The separated crushed particles are the second particles, and the remaining crushed particles that are not separated are the first particles. During the subsequent crystal growth, when heating and melting the material, the larger-sized first particles may reduce a degree of component volatilization, and the smaller-sized second particles may fill gaps between the first particles, thereby improving a heat transfer capability and reducing power loss. In some embodiments, the first particles and the second particles may be separated by a sieving machine.

In 1222, the impurity removal is performed on the crushed particles.

Since the impurities may be introduced into the crushed particles during a crushing process and a separation process of the crushed particles, it is necessary to perform the impurity removal on the crushed particles so as to avoid impurity interference as much as possible, and improve accuracy and reliability of subsequently measured data. In some embodiments, the impurities may also include a transition substance (e.g., transition metal ions), other substances (e.g., oxidation products of the raw material, e.g., SiO2), or the like.

In some embodiments, step 1222 may include: performing the acid washing on the crushed particles.

In some embodiments, the impurity removal may be performed by a method of acid washing. Exemplarily, the crushed particles may be acid washed by using a mixed acid having a volume ratio of hydrofluoric acid (HF) to hydrochloric acid (HCl) of 1:1. HF may be used to remove SiO2, and HCl may be used to remove metal impurity ions.

In 1223, the crushed particles are washed and dried after the impurity removal.

After the impurity removal is completed, substances used during the impurity removal process (e.g., acid, or the like) may be attached to the surfaces of the crushed particles. By washing the crushed particles after the impurity removal, physical matters attached to the crushed particles during the impurity removal process may be removed, thereby reducing interference and improving accuracy.

In some embodiments, the washed crushed particles may be dried to remove water attached to the surfaces of the crushed particles during the washing process, thereby reducing interference and improving accuracy.

In some embodiments, step 1223 may include performing ultrasonic water washing on the crushed particles after the impurity removal, drying the crushed particles after the ultrasonic water washing, and grinding the crushed particles after the drying.

In some embodiments, the crushed particles after the impurity removal may be water washed in an ultrapure water medium by using an ultrasonic device to remove the acid attached to a surface of the crushed particles. In some embodiments, if a time for ultrasonic water washing is too short, an effect of removing the acid attached to a surface of the crushed particles may be unsatisfactory. While if the time for ultrasonic water washing is too long, it may seriously restrict production progress, and it may also further refine the larger-sized first particles into the smaller-sized second particles, which is unfavorable for particle size control of the crushed particles. In some embodiments, the time for ultrasonic water washing may be 20 min to 50 min, so as to remove the acid attached to a surface of the crushed particles as much as possible. Exemplarily, the time for ultrasonic water washing may be 30 min.

In some embodiments, when the drying the crushed particles after the ultrasonic water washing, if a drying temperature is too low, a longer drying time is required, and a drying effect is unsatisfactory. If the drying temperature is too high, the crushed particles may agglomerate, causing an increase in the particle size of the crushed particles and a waste of power. In some embodiments, the drying temperature may be 120°C to 170°C, so as to achieve the better drying effect. Exemplarily, the drying temperature may be 150°C. In some embodiments, the drying time may be negatively correlated with the drying temperature. In some embodiments, the drying may be performed for 12 hours under the drying temperature of 150°C.

In some embodiments, since the content of impurities in the dried crushed particles is low, a pre-treatment may be performed to facilitate subsequent analysis. In some embodiments, the dried crushed particles may be ground to facilitate determining the blend ratio of various components of the crushed particles. In some embodiments, to reduce a grinding difficulty, the smaller-sized second particles may be ground. To reduce material waste, and since components of the crushed particles are the same, only a portion of the second particles may be ground. That is, the grinding the dried crushed particles may include: grinding at least a portion of the second particles.

In 1230, based on the processed remaining material, a fresh material is supplemented, and a new raw material capable of being used for crystal growth is prepared.

In some embodiments, based on the processed remaining material, the blend ratio of various components of the crushed particles may be determined. Based on the preset blending ratio of the raw material for crystal growth, the fresh material may be supplemented accordingly to prepare the new raw material capable of being used for crystal growth.

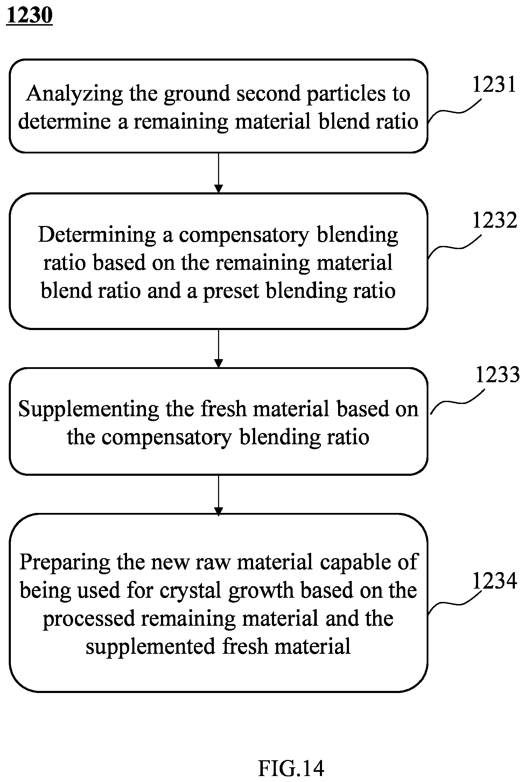

FIG. 14 is a flowchart illustrating an exemplary process for preparing the new raw material for crystal growth according to some embodiments of the present disclosure. Referring to FIG. 14, in some embodiments, step 1230 may include a plurality of sub-steps, e.g., step 1231, step 1232, step 1233, and step 1234.

In 1231, the ground second particles are analyzed to determine the remaining material blend ratio.

In some embodiments, since the second particles are small in size and the grinding is convenient, at least one set of samples may be taken from the second particles for the grinding. In some embodiments, the grinding may be performed by a mortar. In some embodiments, at least 5 sets of samples may be ground to improve accuracy.

In some embodiments, quantitative analysis of elements and their contents in ground sample powder may be performed by using a mechanical instrument (e.g., an element testing and analysis instrument), so as to determine the remaining material blend ratio and the content of various components in the remaining material in the crucible 110.

In 1232, a compensatory blending ratio is determined based on the remaining material blend ratio and a preset blending ratio.

The preset blending ratio refers to the blending ratio of the raw material for crystal growth cultivated for crystal growth. The preset blending ratio may be temporarily added by a user, or may be obtained from past records.

Based on the preset blending ratio and the remaining material blend ratio, the compensatory blending ratio required for adjusting the blend ratio of various components in the remaining material to the preset blending ratio may be determined.

In 1233, the fresh material is supplemented based on the compensatory blending ratio.

After the compensatory blending ratio is determined, corresponding the fresh material may be supplemented according to the compensatory blending ratio.

In 1234, the new raw material capable of being used for crystal growth is prepared based on the processed remaining material and the supplemented fresh material.

Based on mixing the processed remaining material and the supplemented fresh material, the new raw material required for the next crystal growth is obtained.

In some embodiments, since obvious volatilization behavior exists during crystal growth, to compensate for a volatilized portion, random sampling may be performed on volatilized matter to obtain a volatilization blending ratio. Based on the volatilization blending ratio, excess powder may be added to the prepared new raw material to compensate for the volatilization, thereby improving accuracy of crystal growth.

In 1240, crystal growth is performed based on the new raw material.

Based on the prepared new raw material, the next crystal growth is performed.

Basic concepts have been described hereinabove. It is apparent to those skilled in the art that the foregoing detailed description is merely by way of example and is not intended to be limiting of the present disclosure. Although not expressly stated herein, those skilled in the art may make various modifications, improvements, and alterations to the present disclosure. Such modifications, improvements, and alterations are contemplated by the present disclosure and are intended to be within the spirit and scope of the exemplary embodiments of the present disclosure.

It is also noted that the present disclosure employs specific terminology to describe the embodiments of the present disclosure. As used herein, 'an embodiment', 'one embodiment', and/or 'some embodiments' refer to a particular feature, structure, or characteristic related to at least one embodiment of the present disclosure. Accordingly, it should be emphasized and noted that references to 'one embodiment' or 'an embodiment' or 'an alternative embodiment' in different locations in the present disclosure do not necessarily refer to the same embodiment. Moreover, certain features, structures, or characteristics in one or more embodiments of the present disclosure may be combined appropriately.

Similarly, it should be noted that, to simplify the description of the present disclosure and to aid in the understanding of one or more embodiments thereof, various features are sometimes grouped into a single embodiment, a figure, or a description thereof in the foregoing description of the embodiments of the present disclosure. However, this method of description does not imply that features required by the subject matter of the present disclosure are more numerous than those expressly recited in the claims. Indeed, features of an embodiment may be fewer than all features of a single embodiment described in the foregoing disclosure.

In some embodiments where numbers are used to describe the quantity of components and/or properties, it should be understood that numerical parameters used in the present disclosure and the claims are all approximate values, which approximate values may vary depending on the characteristics required by individual embodiments. In some embodiments, the numerical parameters should consider the specified significant digits and adopt conventional methods of rounding. While numerical ranges and parameters provided in some embodiments of the present disclosure to delineate the scope thereof are approximate values, in specific embodiments, such values are set as precisely as possible within the feasible range.

Finally, it should be understood that the embodiments described in the present disclosure are merely for the purpose of illustrating the principles of the embodiments of the present disclosure. Other variations may also fall within the scope of the present disclosure. Accordingly, by way of example and not limitation, alternative configurations of the embodiments of the present disclosure may be considered consistent with the teachings of the present disclosure. Accordingly, the embodiments of the present disclosure are not limited to the embodiments expressly introduced and described in the present disclosure.

## Claims

1. An apparatus for crystal growth, comprising:
a crucible configured to contain a raw material for crystal growth;
a seed holder, at least a portion of the seed holder being capable of being immersed in a melt formed by the raw material for crystal growth in the crucible; the seed holder comprising a seed bonding surface; and
a first support structure, connected to a side of the seed holder opposite to the seed bonding surface, the first support structure being configured to drive the seed holder to rotate.

2. The apparatus for crystal growth according to claim 1, wherein the seed holder is arranged at a bottom portion of the crucible, the seed bonding surface is arranged at a top portion of the seed holder, and a bottom portion of the seed holder is connected to the bottom portion of the crucible via the first support structure.

3. The apparatus for crystal growth according to claim 2, wherein the first support structure comprises a fixing member fixed to the bottom portion of the crucible, and a rotating member rotatably connected to the fixing member, the rotating member being connected to the bottom portion of the seed holder.

4. The apparatus for crystal growth according to claim 2, wherein the apparatus for crystal growth further comprises a first rotating mechanism located outside the crucible, the first rotating mechanism being magnetically connected to the first support structure, and the first rotating mechanism drives the first support structure to rotate via a magnetic force.

5. The apparatus for crystal growth according to claim 1, wherein the seed holder is arranged at a top portion of the melt, the seed bonding surface is located at a bottom portion of the seed holder, and the first support structure is in a driving connection with a second rotating mechanism.

6. The apparatus for crystal growth according to claim 1, wherein the apparatus for crystal growth comprises a second support structure, the raw material for crystal growth comprises at least one source rod, the at least one source rod is capable of being at least partially immersed in the melt, and one end of each of the at least one source rod is connected to the second support structure.

7. The apparatus for crystal growth according to claim 6, wherein the apparatus for crystal growth comprises a driving structure, the second support structure comprises a main rod and a plurality of auxiliary rods spaced apart from each other, one end of each of the plurality of auxiliary rods is respectively connected to at least one of the at least one source rod, the other end of each of the plurality of auxiliary rods is connected to the main rod, the main rod is connected to the driving structure, and the driving structure drives the second support structure to move so that different source rods are capable of being immersed in the melt.

8. The apparatus for crystal growth according to claim 7, wherein the main rod is connected to a telescopic structure, or each of the plurality of auxiliary rods is connected to a telescopic structure, and the telescopic structure extends and retracts to immerse a source rod connected with the each of the plurality of auxiliary rods in the melt or to lift the source rod out of the melt.

9. The apparatus for crystal growth according to claim 6, wherein the second support structure is in a driving connection with a third rotating mechanism, and the third rotating mechanism drives the second support structure to rotate so as to drive the at least one of the at least one source rod to rotate.

10. The apparatus for crystal growth according to claim 5, wherein
the first support structure comprises a plurality of support rods connected end-to-end in sequence, and any two adjacent support rods are nested and connected via a bearing;
a rotation speed of the first support structure is 10 rpm-200 rpm.

11. The apparatus for crystal growth according to claim 10, wherein the rotation speed of the first support structure is negatively correlated with a temperature at the seed holder.

12. The apparatus for crystal growth according to claim 5, wherein the apparatus for crystal growth further comprises a cooling assembly, the cooling assembly comprises a flow guide structure arranged in the seed holder, and the flow guide structure is configured to guide a cooling medium, so that the cooling medium cools the seed bonding surface.

13. The apparatus for crystal growth according to claim 12, wherein the cooling assembly further comprises a hollow structure arranged in the first support structure, and the hollow structure cooperates with the flow guide structure.

14. The apparatus for crystal growth according to claim 13, wherein the hollow structure comprises a first cooling channel and a second cooling channel, the flow guide structure comprises a flow guiding ring arranged in the seed holder, an inner hole of the flow guiding ring is in communication with the first cooling channel, and a cavity space between the flow guiding ring and a housing of the seed holder is in communication with the second cooling channel; the cavity space is in communication with the inner hole.

15. The apparatus for crystal growth according to claim 14, wherein the first cooling channel is arranged in the second cooling channel, and the second cooling channel surrounds the first cooling channel; a top end of the cavity space is in communication with the second cooling channel, and a bottom end of the cavity space is in communication with the inner hole.

16. The apparatus for crystal growth according to claim 13, wherein the flow guide structure comprises a central channel and a peripheral channel, the peripheral channel is arranged surrounding the central channel, a flow guide inlet of the central channel and a flow guide inlet of the peripheral channel are both arranged at a top portion of the seed holder, the flow guide inlet of the central channel and the flow guide inlet of the peripheral channel are respectively in communication with the hollow structure, a flow guide outlet of the peripheral channel is located at an edge region of the seed bonding surface, and a flow guide outlet of the central channel is located at a central region of the seed bonding surface.

17. The apparatus for crystal growth according to claim 16, wherein the seed bonding surface of the seed holder is provided with a baffle plate, an area of the baffle plate is larger than an area of the seed bonding surface in a direction perpendicular to the seed bonding surface, an edge of the baffle plate is provided with a flow guide plate, and the flow guide plate extends from the edge of the baffle plate toward a top direction of the seed holder.

18. The apparatus for crystal growth according to claim 17, wherein an angle between the flow guide plate and the baffle plate is 95°-130°.

19. The apparatus for crystal growth according to claim 1, wherein a side portion and a top portion of the seed holder are coated with a protective layer.

20. The apparatus for crystal growth according to claim 5, wherein a middle portion of the seed bonding surface is provided with a bonding region, the seed bonding surface is provided with a guiding structure, the guiding structure is capable of forming a guiding channel, and the bonding region is located in the guiding channel.

21. The apparatus for crystal growth according to claim 20, wherein
the seed holder comprises a first layer structure, a second layer structure, and a third layer structure sequentially arranged along a height direction,
the first layer structure is configured to be connected to the first support structure;
the second layer structure is provided with a slot, the slot is configured to cooperate and engage with a mounting plate, and a side of the mounting plate facing away from the first layer structure is provided with a seed mounting surface;
the third layer structure is provided with the guiding structure.

22. The apparatus for crystal growth according to claim 20, wherein the guiding structure comprises guiding protrusions arranged on two sides of the seed bonding surface, the guiding channel is formed between the two guiding protrusions, a middle portion of the guiding channel is provided with a mounting protrusion, and the bonding region is located on the mounting protrusion.

23. The apparatus for crystal growth according to claim 20, wherein the guiding structure comprises guiding protrusions arranged on two sides of the seed bonding surface, the guiding channel is formed between the two guiding protrusions, and the bonding region is located at a middle portion of the guiding channel.

24. The apparatus for crystal growth according to claim 20, wherein the guiding structure comprises a plurality of guiding protrusions arranged surrounding the bonding region, the plurality of guiding protrusions respectively extend from an edge of the seed bonding surface toward the bonding region at the middle portion of the seed bonding surface, and the guiding channel is formed between any adjacent guiding protrusions.

25. The apparatus for crystal growth according to claim 20, wherein a height difference of the guiding structure is less than or equal to 1 mm.

26. The apparatus for crystal growth according to claim 20, wherein a ratio of a diameter of the seed holder to an inner diameter of the crucible is 4/5~7/8.

27. The apparatus for crystal growth according to claim 1, wherein a ratio of a diameter of the seed holder to a diameter of a crystal is 0.5-1.5.

28. The apparatus for crystal growth according to claim 1, wherein the crucible is connected to a third support structure.

29. The apparatus for crystal growth according to claim 28, wherein a ratio of a rotation speed of the third support structure to the rotation speed of the first support structure is 0.4-0.75.

30. A method for crystal material recycling, comprising:
after a crystal growth ends, acquiring a solidified remaining raw material in a crucible;
processing the remaining material; and
based on the processed remaining material, supplementing a fresh material to prepare a new raw material capable of being used for crystal growth.

31. The method according to claim 30, wherein the processing the remaining material comprises:
crushing the remaining material to obtain crushed particles;
performing impurity removal on the crushed particles; and
washing and drying the crushed particles after the impurity removal.

32. The method according to claim 31, wherein the performing impurity removal on the crushed particles comprises:
performing acid washing on the crushed particles.

33. The method according to claim 31, wherein the washing and drying the crushed particles after the impurity removal comprises:
performing ultrasonic water washing on the crushed particles after the impurity removal;
drying the crushed particles after the ultrasonic water washing; and
grinding the crushed particles after the drying.

34. The method according to claim 33, wherein the method further comprises:
screening a particle size of the crushed particles to obtain first particles having a particle size greater than or equal to a preset threshold and second particles having a particle size less than the preset threshold;
the grinding the crushed particles after the drying comprises:
grinding at least a portion of the second particles;
based on the processed remaining material, supplementing a fresh material to prepare a new raw material for crystal growth, comprising:
analyzing the ground second particles to determine a remaining material blend ratio;
determining a compensatory blending ratio based on the remaining material blend ratio and a preset blending ratio;
supplementing the fresh material based on the compensatory blending ratio; and
preparing the new raw material capable of being used for crystal growth based on the processed remaining material and the supplemented fresh material.
